(19) Europäisches Patentamt

European Patent Office

Office européen des brevets

(11) **EP 4 068 033 B1**

(12) **EUROPEAN PATENT SPECIFICATION**

(45) Date of publication and mention
of the grant of the patent:
**10.07.2024  Bulletin 2024/28**

(21) Application number: **21305408.3**

(22) Date of filing: **31.03.2021**

(51) International Patent Classification (IPC):
**G05D 1/48** *(2024.01)*    **G05D 1/689** *(2024.01)*
**G05D 1/00** *(2024.01)*    **G06F 11/36** *(2006.01)*
**B25J 9/16** *(2006.01)*    **G06N 3/02** *(2006.01)*
**G06N 3/084** *(2023.01)*   **G06N 3/04** *(2023.01)*
**G05B 13/02** *(2006.01)*   **G05B 17/02** *(2006.01)*
**G05D 101/15** *(2024.01)*  **G05D 107/70** *(2024.01)*
**G05D 109/10** *(2024.01)*

(52) Cooperative Patent Classification (CPC):
**G06N 3/04; G05D 1/48; G05D 1/6895; G06N 3/084;**
G05B 13/027; G05B 17/02; G05D 2101/15;
G05D 2107/70; G05D 2109/10; G06F 30/17;
G06F 30/20; G06F 30/27

(54) **METHOD AND DEVICE FOR SIMULATING A ROBOTIC SYSTEM**

VERFAHREN UND VORRICHTUNG ZUR SIMULATION EINES ROBOTERSYSTEMS

PROCÉDÉ ET DISPOSITIF DE SIMULATION D'UN SYSTÈME ROBOTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.10.2022  Bulletin 2022/40**

(73) Proprietor: **Commissariat à l'Energie Atomique et
aux Energies
Alternatives
75015 Paris (FR)**

(72) Inventors:
• **HILL, Ashley
91190 GIF SUR YVETTE (FR)**
• **LUCET, Eric
91190 GIF SUR YVETTE (FR)**

(74) Representative: **Cabinet Beaumont
4, Place Robert Schuman
B.P. 1529
38025 Grenoble Cedex 1 (FR)**

(56) References cited:
**US-A1- 2020 156 241**

• **ERDOGMUS DENIZ ET AL: "A Neural Network
Perspective to Extended Luenberger Observers",
MEASUREMENT AND CONTROL., vol. 35, no. 1,
1 February 2002 (2002-02-01), GB, pages 10 - 16,
XP055827599, ISSN: 0020-2940, Retrieved from
the Internet
<URL:https://citeseerx.ist.psu.edu/viewdoc/dow
nload?doi=10.1.1.114.1487&rep=rep1&type=pdf
> [retrieved on 20210727], DOI:
10.1177/002029400203500103**
• **HOVAKIMYAN N ET AL: "On approximate NN
realization of an unknown dynamic system from
its input-output history", AMERICAN CONTROL
CONFERENCE, 2000. PROCEEDINGS OF THE
2000 JUNE 28-30, 2000, PISCATAWAY, NJ,
USA,IEEE, vol. 2, 28 June 2000 (2000-06-28),
pages 919 - 923, XP010516788, ISBN:
978-0-7803-5519-4**

**Description**

Technical field

The present disclosure relates generally to the field of robotic systems, and in particular to a method and device for simulating the behavior of a robotic system.

Background art

The conception and/or implementation of controllers for complex robotic systems, such as robotic vehicles, generally requires an accurate model of the behavior of the robotic system. Such a model is used to estimate, by simulation based on a current state, a future state of the robotic system.

For example, during the conception of a controller for a robotic system, the design and settings of the controller are determined based on a simulation of the robotic system, requiring an accurate model of the behavior of the robotic system.

Furthermore, certain controllers, such as model predictive controllers, incorporate a model of the behavior of the robotic system for the purpose of generating precise commands that enable a given setpoint to be attained.

There is, however, a technical difficulty in providing a model of a robotic system permitting an accurate, stable and reliable simulation of the behavior of the robotic system. Document US2020/0156241 relates to automatic safety and performance robustness through uncertainty driven learning and control.

The publication by Erdogmus Deniz et al. entitled "A Neural Network Perspective to Extended Luenberger Observers", MEASUREMENT AND CONTROL., [Online] vol . 35, no. 1, 1 February 2002, pages 10-16, relates to a neural network perspective to extended Luenberger observers.

The publication by Hovakimyan N et al. entitled "On approximate NN realization of an unknown dynamic system from its input-output history", AMERICAN CONTROL CONFERENCE, 2000, PROCEEDINGS OF THE 2000 JUNE 28-30, 2000, PISCATAWAY, NJ, USA, IEEE, [Online], vol. 2, 28 June 2000 (2000-06-28), pages 919-923, relates to an approximate NN realization of an unknown dynamic system from its input-output history.

Summary

It is an aim of embodiments of the present disclosure to at least partially address one of more difficulties in the prior art.

The invention is defined by the appended set of claims.

Brief description of drawings

The foregoing features and advantages, as well as others, will be described in detail in the following description of specific embodiments given by way of illustration and not limitation with reference to the accompanying drawings, in which:

Figure 1 schematically illustrates a system for the conception of a controller of a robotic system according to an example embodiment of the present disclosure;

Figure 2 schematically illustrates a robotic system comprising a controller according to an example embodiment of the present disclosure;

Figure 3 schematically represents a simulator of a robotic system according to an example embodiment of the present disclosure;

Figure 4 schematically illustrates a computing system implementing the robotic system simulator of Figure 3 according to an example embodiment of the present disclosure;

Figure 5 schematically represents a training system for training a neural network of the robotic system simulator of Figure 3 according to non-claimed embodiment of the present disclosure;

Figure 6 schematically illustrates a computing system implementing the training system of Figure 5;

Figure 7 schematically illustrates a neural network of the simulator of Figure 3 and of the training system of Figure 5 according to an example embodiment of the present disclosure;

Figure 8 schematically illustrates the neural network of Figure 7 according to a further example embodiment of the present disclosure;

Figure 9 represent a kinematic robot model according to an example embodiment;

Figure 10 is a graph representing simulated displacement of a robot vehicle using the robotic system model described herein; and

Figure 11 is a graph representing angular heading of the robot vehicle using the robotic system model described herein.

Description of embodiments

Like features have been designated by like references in the various figures. In particular, the structural and/or functional features that are common among the various embodiments may have the same references and may dispose identical structural, dimensional and material properties.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc, reference is made to the orientation shown in the figures.

Unless specified otherwise, the expressions "around", "approximately", "substantially" and "in the order of" signify within 10 %, and preferably within 5 %.

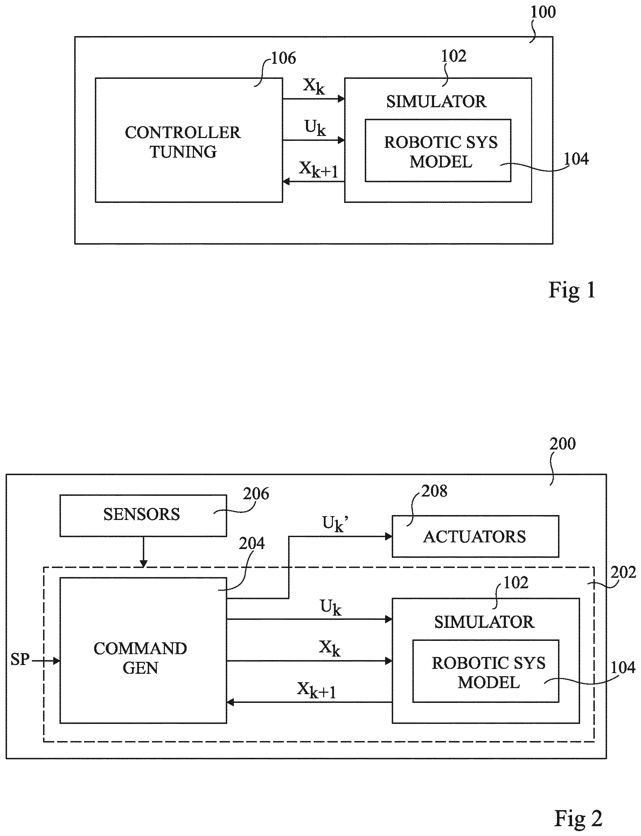

As mentioned above in the background section, the conception and implementation of controllers for complex robotic systems, such as robotic vehicles, generally requires an accurate model of the behavior of the robotic system. Examples of such applications of a robotic system model will now be described with reference to Figures 1 and 2.

Figure 1 schematically illustrates a system 100 for the conception of a controller of a robotic system according to an example embodiment of the present disclosure. The system 100 comprises a simulator (SIMULATOR) 102 of the robotic system comprising a model (ROBOTIC SYS MODEL) 104 of the robotic system, and a controller tuning module (CONTROLLER TUNING) 106.

The controller tuning module 106 is configured to determine the settings and parameters of a controller for a robotic system, based on the simulated behavior of the robotic system. The behavior is simulated by the simulator 102 using the robotic system model 104. For example, during the conception process, the module 106 supplies to the simulator 102 a state vector $X_k$, in the form of a digital signal, indicating a state of the robotic system at a timestep k, and a command vector $U_k$, also in the form of a digital signal, indicating values of one or more control signals applied to the robotic system at the timestep k. In some embodiments, one or more further variables, in the form of further digital signals, may additionally be supplied to the simulator 102, including for example values indicating environmental conditions of the robotic system, such as temperature, ground conditions, windspeed and direction, etc.

The simulator 102 is configured to return, for example, a next state vector $X_{k+1}$, in the form of a digital signal, indicating the estimated state of the robotic system at a next timestep $k + 1$, in other words after a time lapse $dt$.

Figure 2 schematically illustrates a robotic system 200 comprising a controller 202 according to an example embodiment of the present disclosure.

The controller 202 is for example a model-based controller with the addition of state estimators, and comprises a command generator (COMMAND GEN) 204 and the simulator (SIMULATOR) 102 similar to that of Figure 1 comprising the robotic system model (ROBOTIC SYS MODEL) 104.

The robotic system 200 further comprises one or more sensors (SENSORS) 206 and one or more actuators (ACTUATORS) 208.

The controller 202 receives signals captured by the sensors 206. For example, the sensors are configured to capture analog signals, such as current or voltage signals, that are then sampled and converted into digital values that are provided to the controller 202. Alternatively, one or some of the sensors 206 may supply analog signals to the controller 202, and the controller 202 comprises a suitable interface for sampling and converting these signals into digital signals.

The controller 202 uses the sensor signals to determine a current state $X_k$ of the robotic system 200. The command generator 204 for example receives a setpoint SP, which is a digital value indicating a desired next state of the robotic system. The setpoint SP is for example generated by a control algorithm implemented within, or external to, the robotic system 200. Based on the current state $X_k$ and on the setpoint SP, the command generator is for example configured to generate an initial command vector $U_k$ indicating values of one or more command signals to be applied to the robotic system 200.

The controller 202 for example uses the simulator 102 to simulate the behavior of the robotic system in view of the initial command vector $U_k$. For this, the command generator 204 supplies to the simulator 102 the current state vector $X_k$, in the form of a digital signal, indicating a current state of the robotic system at a timestep $k$, and the initial command vector $U_k$, also in the form of a digital signal. In some embodiments, one or more further variables, in the form of further digital signals, may additionally be supplied to the simulator 102, including for example values indicating environmental conditions of the robotic system 200, such as temperature, ground conditions, windspeed and direction, etc.

The simulator 102 is configured to return, for example, a next state vector $X_{k+1}$, in the form of a digital signal, indicating the estimated state of the robotic system at a next timestep $k + 1$, in other words after a time lapse $dt$.

The command generator 204 is then for example configured to correct the command vector $U_k$, based for example on a comparison between the estimated next state vector $X_{k+1}$ and the setpoint SP. The command generator 204 then for example applies the corrected command vector $U_k'$ to the one or more actuators 208. The process is then for example repeated after a time interval $dt$ corresponding to the size of the timesteps.

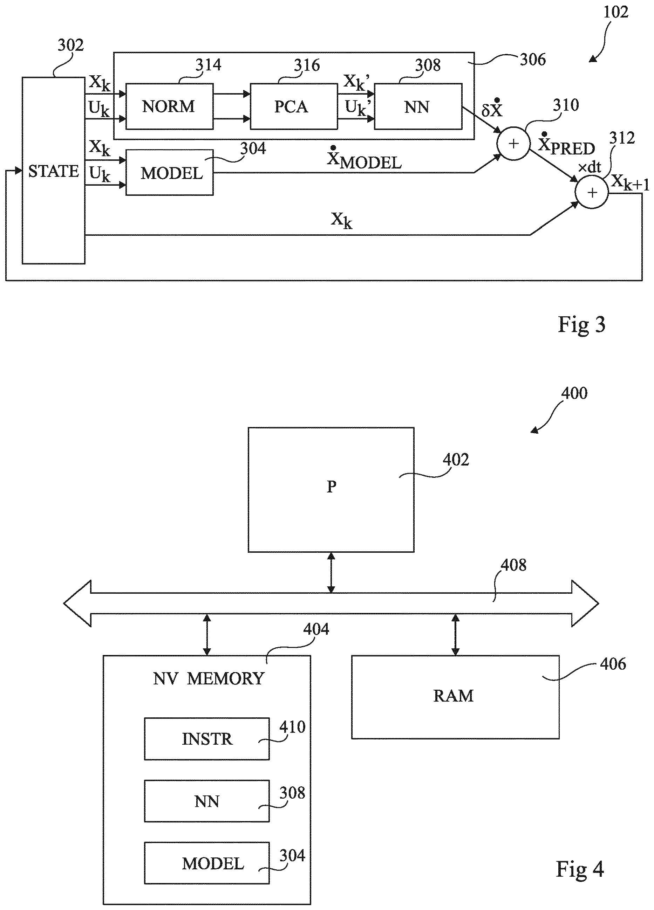

Figure 3 schematically represents the simulator 102 of Figures 1 and 2 according to an example embodiment of the present disclosure.

The simulator 102 for example receives, as inputs, the state (STATE) 302 of the robotic system, including for example at least the state vector $X_k$ and the command vector $U_k$. These vectors are for example in the form of digital data values that are processed as digital signals by a processing device implementing the simulator. In some embodiments, one or more further variables, in the form of further digital signals, may additionally be supplied to the simulator 102, including for example values indicating environmental conditions of the robotic system 200, such as temperature, ground conditions, windspeed and direction, etc.

The input state 302 is provided to a model (MODEL) 304 of the robotic system, and to a correction module 306, comprising a neural network (NN) 308. Furthermore, in some cases, some further variables may be used by the neural network 308, but not by the approximative model 304. Indeed, as will be described in more detail below, the neural network 308 may have been trained to take into account additional variables not considered by the approximative model 304.

The model 304 does not comprise a neural network, and is for example an existing model that approximates the behavior of the robotic system. For example, the model 304 is based on known laws of physics, represented by one or more equations with parameters that have been tuned, and which are solved by entering the input state 302. In some cases, the model 304 is an existing model already developed for a robotic system similar to or of the same type as the robotic system 200. Indeed, the use of models for approximating the behavior of a broad range of robotic systems has been known for many years, and many such models have already been developed, providing a large catalog of possible models for various types of robotic systems. However, the use of such a model alone is not sufficiently accurate for many applications, particularly safety critical applications, such as autonomous vehicles, where errors of just a few tens of centimeters can result in a collision.

The model 304 is for example configured to generate, as its output, an estimate of the rate of change of the state vector over time. This estimate is for example in the form of a rate of change vector $\dot{X}_{MODEL}$, comprising digital values indicating the rate of change over time of the state vector $X_k$ based on the command vector $U_k$ and any other variables that are considered by the model 304. In the case that there are no other variables that are considered, this can be represented as:

$$\dot{X}_{MODEL} = MODEL(X_k, U_k)$$

where MODEL() is the approximative robotic model 304.

The neural network 308 of the correction module 306 has been trained to correct the output of the approximative model 304. For example, the neural network 308 has been trained with real world data, in a supervised manner, to predict a difference between the real world behavior of the robotic system and the approximative model 304. The correction model 306 is for example configured to generate a correction vector $\delta\dot{X}$ indicating this difference in the form of a correction to be applied to the rate of change vector $\dot{X}_{MODEL}$. For example, the correction vector $\delta\dot{X}$ comprises, for each value of the rate of change vector $\dot{X}_{MODEL}$, a corresponding correction value that brings the difference to zero.

As represented by an adder 310 in Figure 3, the rate of change vector $\dot{X}_{MODEL}$ and the correction vector $\delta\dot{X}$ are for example added in order to generate a corrected rate of change vector $\dot{X}_{PRED}$. This vector $\dot{X}_{PRED}$ comprises digital values that for example improve the realism of the simulation with respect to the rate of change vector $\dot{X}_{MODEL}$ alone.

In some embodiments, this corrected rate of change vector $\dot{X}_{PRED}$ is then used with the current state vector $X_k$ as an integrator, in order to estimate the next state vector $X_{k+1}$ after the time interval $dt$. Indeed, as represented by a further operator 312, an Euclidean integration is for example performed in which the corrected rate of change vector $\dot{X}_{PRED}$ is multiplied by the time interval $dt$, in the form of a digital value, and added to the current state vector $X_k$, in order to estimate the next state vector $X_{k+1}$. In some embodiments, the next state $X_{k+1}$ is fed back to form a new current state vector $X_k$ during a subsequent iteration of the robotic simulation.

In some embodiments, in addition to the neural network 308, the correction module 306 further comprises a normalization module (NORM) 314 and/or a principal component analysis transformation module (PCA) 316, that are configured to process the inputs data values of the module 306 prior to them being applied to the neural network 308.

The normalization module 314 is for example configured to adjust the input data values so that their data distribution is centered around the activation function of the neural network 308. For example, in one embodiment, the normalization is a gaussian normalization, and the input values are centered to a $\mu = 0$, $\sigma = 1$ gaussian distribution.

The PCA transformation module 316 is for example configured to apply a PCA transformation to the normalized data values. A PCA transformation has the advantage of keeping each feature of the dataset of input data values orthogonal to each other, meaning that their variance is decorrelated. This helps the neural network to observe specific changes in the environment, as only a single value changes. PCA transformation is described in more detail in the publication by K. Pearson entitled "Liii. on lines and planes of closest fit to systems of points in space", The London, Edinburgh and Dublin Philosophical Magazine and Journal of Science, vol. 2, no. 11, pp. 559-572, 1901.

The normalization and PCA transformation pretreatments of the input data have the advantages of reducing the workload on the neural network 308, speeding up training, and providing repeatable results. With these pretreatments, the corrected rate of change vector $\dot{X}_{PRED}$ can be represented by the following equation:

$$\dot{X}_{PRED} = MODEL(X_k) + NN(PCA(Norm(X_k)))$$

where $NN()$ is the processing of the neural network, $PCA()$ is the PCA transformation, and $Norm()$ is the normalization operation. Thus, the model $MODEL()$ and the neural network $NN()$ work in conjunction with each other in order to generate an accurate prediction of the next state.

The normalization and PCA transformation pretreatments are merely two examples of pretreatments that can be applied to the data before it is fed to the neural network 308. Other pretreatments that could additionally or alternatively be applied include the use of variational auto-encoder neural network.

Figure 4 schematically illustrates a computing system 400 implementing the simulator 102 of Figure 3 according to an example embodiment of the present disclosure. The computing system 400 for example comprises a processing device (P) 402, a non-volatile memory (NV MEMORY) 404 and a volatile memory (RAM) 406, which is for example a random-access memory, interconnected by a communications bus 408. The processing device 402 for example comprises one or more processors under control of computing instructions (INSTR) 410 stored in the non-volatile memory 404. While not illustrated in Figure 4, there may be further devices or components forming part of the computing system 400, such as a user interface, communications and/or network interface for communicating data outside the system, etc.

The neural network (NN) 308 and the approximative model (MODEL) 304 are also for example stored in the memory. For example, the model 304 is defined by a computing code that implements the one or more equations for generating the result of this model. The neural network 308 is for example defined by its various parameters, its number of layers and the number of neurons in each layer, its activation functions, and/or other features of the network. The implementation of the various modules of the simulator 102 is for example performed in software by the computing instructions when executed by the processing device 402.

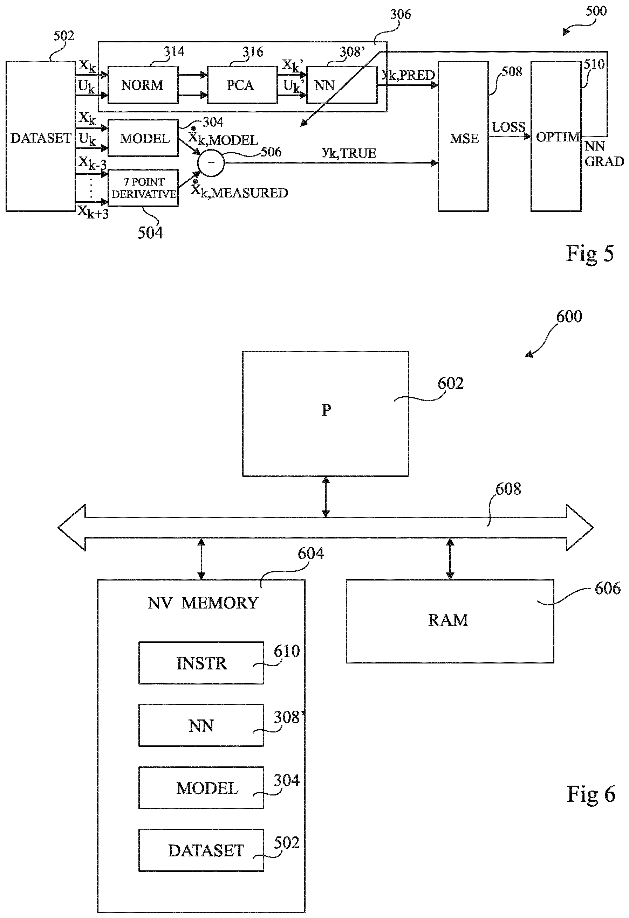

Figure 5 schematically represents a training system 500 for training the neural network 308 of the simulator 102 of Figure 3 according to a non-claimed embodiment of the present disclosure.

The system 500 for example comprises the correction module 306, comprising for example the normalization (NORM) and PCA transformation (PCA) modules 314, 316, and an untrained version 308' of the neural network (NN) 308. The system 500 also comprises the approximative model (MODEL) 304, which is the same as the one of the simulator 102.

The system 500 further comprises a training dataset (DATASET) 502 of training data comprising training data points. In some embodiments, the training data set comprises at least 100k unique data points, allowing a corresponding number of iterations of a control loop for teaching the neural network. In some embodiments, there are at least 1 million data points in the training dataset 502. The training data set for example comprises data measured under a variety of environmental conditions. For example, for the case of an autonomous vehicle, this may include a broad range of grip conditions, weather conditions (wet, dry, frosty, hot, etc.), target speeds, etc.

Each data point comprises a measured state vector $X_k$ of the robotic system, a command vector $U_k$ as applied

to the robotic system, and further measured data permitting a ground truth to be determined. In particular, a subtraction, by a subtractor 506, of the rate of change vector $\dot{X}_{k,MODEL}$ from a real world rate of change vector $\dot{X}_{k,MEASURED}$ provides a ground truth $y_{k,TRUE}$, which the neural network 308' is to be trained to predict. In some embodiments, the neural network 308' is trained not only based on the measured state vector $X_k$ and the command vector, but also based on further state values that are not provided to the approximative model 304. For example, rate of change values associated with such further state values are for example also provided as part of the ground truth $y_{k,TRUE}$ so that the neural network can be trained based on these values.

For example, in some embodiments, the training dataset may comprise a measured rate of change vector $\dot{X}_{k,MEASURED}$. Indeed, in the case that part of the state vector $X_k$ indicates an x,y position of the robotic system, the rate of change vector $\dot{X}_{k,MODEL}$ generated by the model 304 for example indicates a velocity of the robotic system, and the dataset may comprise a measured velocity of the robotic system, which directly provides this part of the measured rate of change vector $\dot{X}_{k,MEASURED}$.

In alternative embodiments, as represented in Figure 5, the measured rate of change vector $\dot{X}_{k,MEASURED}$ may be derived from other measured data. For example, the dataset 502 comprises seven measured real world points $X_{k-3}$ to $X_{k+3}$, and these points are provided to a 7 point derivative calculation module (7 POINT DERIVATIVE) 504, which for example performs a 7 point derivative to generate the measured rate of change vector $\dot{X}_{k,MEASURED}$. In alternative embodiments, a derivative calculation based on a different number of points could be used.

The correction module 306 is for example configured to generate a prediction $y_{k,PRED}$ of the difference between the rate of change vector $\dot{X}_{k,MODEL}$ and the real world rate of change vector $\dot{X}_{k,MEASURED}$.

The prediction $y_{k,PRED}$ and the ground truth $y_{k,TRUE}$ are used to train the untrained neural network 308'. For example, these vectors are provided to loss function calculation module (MSE) 508, which is for example configured to perform a Mean Square Error (MSE) calculation. For example, the neural network 308 is trained in batches of P datapoints of a dataset simultaneously, each datapoint being a vector representing a sample $k$ of the dataset, and for each batch of P datapoints, the module 508 calculates the following loss function:

$$\frac{1}{P}\sum_{k}\left(y_{k,TRUE} - y_{k,PRED}\right)^2$$

with k from 1 to P.

Using this loss function, digital gradient values, NN GRAD, representing a gradient over the parameters of the neural network 308', are for example obtained using an optimizer (OPTIM) 510, and supplied to the neural network 308' to modify the parameters of the network. The optimizer 510 is for example configured to correct the prediction $y_{k,PRED}$ generated by the neural network 308' with respect to the desired output $y_{k,TRUE}$ of the neural network 308'. In some embodiments, the optimizer 510 applies the Adam optimization algorithm, as known by those skilled in the art. Alternatively, another optimization algorithm could be used by the optimizer, such as a Stochastic Gradient Descent (SGD) optimization algorithm, or a Root Mean Square Propagation (RMSProp) optimization algorithm. SGD optimization is described in more detail in the publication by L. Bottou, F. E. Curtis and J. Nocedal, entitled "Optimization methods for large-scale machine learning", Siam Review, vol. 60, no. 2, pp. 223-311, 2018.

Training based on the dataset 502 for example continues until the loss function hits its final plateau, in other words when the loss function finds no new minimum for a given number of timesteps, implying that the accuracy of the neural network 308' is no longer improving. The neural network 308' is then deemed to be trained, and forms the trained neural network 308. In some embodiments, training is performed using a decreasing learning rate, such as a learning rate that reduces by a factor of 2 every time a plateau is reached in the loss function, as described in more detail in the publication by K. He, X.Zhang, S. Ren and J. Sun entitled "Deep residual learning for image recognition", in Proceedings of the IEEE conference on computer vision and pattern recognition, pp. 770-778, 2016. The gradients of the method can for example be considered as a gradient descent method defined by the following equations:

$$\frac{\delta L}{\delta w_i} = \frac{\delta L}{\delta y_{\mathrm{pred}}}\frac{\delta y_{\mathrm{pred}}}{\delta z_N}\left(\prod_{j=N-1}^{i}\frac{\delta z_{j+1}}{\delta s_j}\frac{\delta s_j}{\delta z_j}\right)\frac{\delta z_i}{\delta w_i}$$

$$\frac{\delta L}{\delta b_i} = \frac{\delta L}{\delta y_{\text{pred}}} \frac{\delta y_{\text{pred}}}{\delta z_N} \left( \prod_{j=N-1}^{i} \frac{\delta z_{j+1}}{\delta s_j} \frac{\delta s_j}{\delta z_j} \right) \frac{\delta z_i}{\delta b_i}$$

where $\omega_i$, $b_i$, $s_i$ and $z_i$ are respectively the weights, biases, activation functions and neuron outputs of the neural network described in more detail below, $\frac{\delta L}{\delta y_{PRED}}$ is the derivative of the loss function, $\frac{\delta y_{PRED}}{\delta z_N}$ is the derivative of the outputs'

activation function, $\frac{\delta z_{j+1}}{\delta s_j}$ are the weights at the layer j+1, $\frac{\delta s_j}{\delta z_j}$ are the activation functions at the layer j, $\frac{\delta z_j}{\delta \omega_j}$ is the

activation of the layer $i$ - 1$(s_{i-1})$, and $\frac{\delta z_i}{\delta b_i}$ is equal to 1.

Figure 6 schematically illustrates a computing system 600 implementing the training system 500 of Figure 5. The computing system 600 for example comprises a processing device (P) 602, a non-volatile memory (NV MEMORY) 604 and a volatile memory (RAM) 606, which is for example a random-access memory, interconnected by a communications bus 608. The processing device 602 for example comprises one or more processors under control of computing instructions (INSTR) 610 stored in the non-volatile memory 604. While not illustrated in Figure 6, there may be further devices or components forming part of the computing system 600, such as a user interface, communications and/or network interface for communicating data outside the system, etc.

The neural network (NN) 308' under training and the approximative model (MODEL) 304 are also for example stored in the memory 604. For example, the model 304 is defined by a computing code that implements the one or more equations for generating the result of this model. The neural network 308' is for example defined by its various parameters, its number of layers and the number of neurons in each layer, its activation function, and/or other features of the network. The implementation of the various modules of the training system 500 is for example performed in software by the computing instructions when executed by the processing device 602.

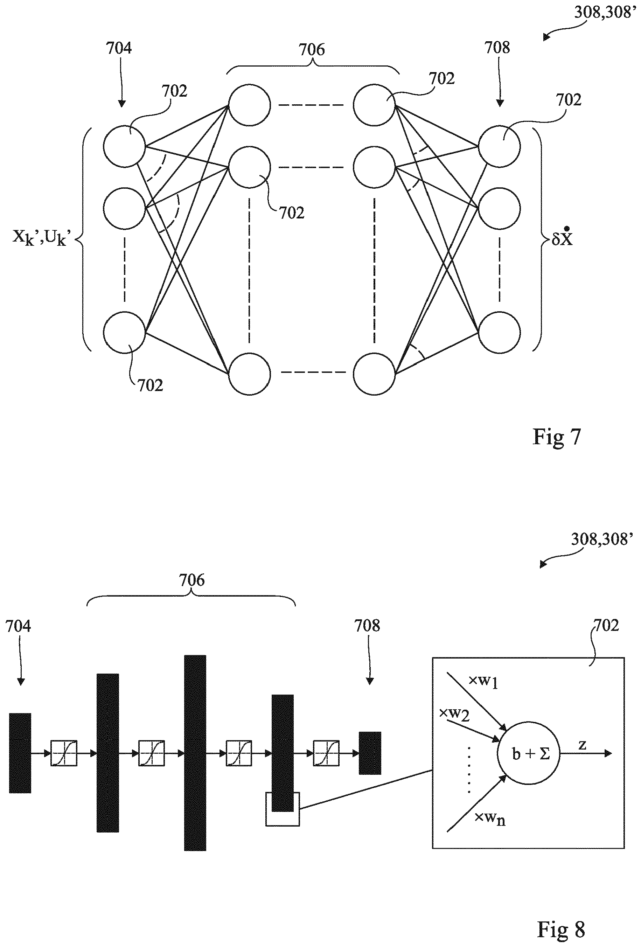

Figure 7 schematically illustrates the neural network 308, 308' according to an example embodiment of the present disclosure, this network for example implementing the trained neural network 308 of Figure 3 and the untrained neural network 308' of Figure 5.

Each layer of the neural network 308, 308' is composed of a plurality of perceptrons 702, i.e. neurons. For example, the network comprises an input layer 704 comprising a plurality of perceptrons 702, one or more hidden layers 706, each hidden layer comprising a plurality of perceptrons 702, and an output layer comprising a plurality of perceptrons 702.

The neural network 308, 308' is for example a fully-connected feed forward neural network, meaning that each perceptron 702 of the input layer 704 is coupled to each perceptron 702 of a first of the hidden layers 706, which is in turn coupled to each perceptron 702 of a next one of the hidden layers, etc., and each perceptron 702 of a final one of the hidden layers 706 is coupled to each perceptron 702 of the output layer 708.

Each perceptron 702 is for example defined by the following equations:

$$z_{j,m} = \sum_i \omega_{j,m,i} s_{j-1,i} + b_{j,m}$$

$$s_{j,m} = a(z_{j,m})$$

where $a$ is the chosen activation function associated with the perceptron or layer, $j$ is the layer of the perceptron, and $m$ is the index of the perceptron at the $j^{th}$ layer.

The output $y_{PRED}$ of the neural network 700 is for example predicted based on the following formula:

$$y_{PRED} = a(b_N + \omega_{N,N-1} a \left( b_{N-1} + \omega_{N-1,N-2} a \left( ... b_1 + \omega_{1,0} input \right) \right))$$

where $N$ is the number layers, including the input and output layer, $\omega_{j,j-1}$ is the weight matrix between the layers $j$ and $j-1$, $b_j$ is the bias vector at the layer $j$, $a$ is the activation function, and *input* is the input to the neural network comprising at least the concatenated state vector $X_k$ and the command vector $U_k$.

Figure 8 schematically illustrates the neural network 308, 308' according to an example embodiment in which it comprises three hidden layers 706. Figure 8 also illustrates an example of a perceptron 702 of one of the hidden layers receiving a signal from each perceptron 1 to n of the previous layer weighted by a corresponding weight $\omega_1$ to $\omega_n$, and the computation of the output signal $z$ of the perceptron based on the bias vector and the sum indicated above.

The present inventors have found that a perceptron neural network having ten hidden layers of 256 perceptrons 702 provides satisfactory results for a model of an autonomous vehicle. Furthermore, they have found the ReLU activation function, as described in more detail in the publication by X. Glorot, A. Bordes and Y. Bengio, entitled "Deep sparse rectifier neural networks", in Proceedings of the fourteenth international conference on artificial intelligence and statistics, pp. 315-323, 2011, provides good results. Indeed, an advantage of such an activation function is that it avoids vanishing gradients when backpropagating, which improves training time efficiency and the performance of the trained network. Furthermore, for regularization reasons and to avoid overfitting, a batchnorm layer is for example placed between each of the layers of the neural network, as described in more detail in the publication by S. Ioffe and C. Szegedy entitled "Batch normalization: Accelerating deep network training by reducing internal covariate shift", 2015. Of course, the type and size of the neural network will depend on the particular application. For example, if the input state involves video image data, a convolutional neural network is for example used for at least that portion of the input state.

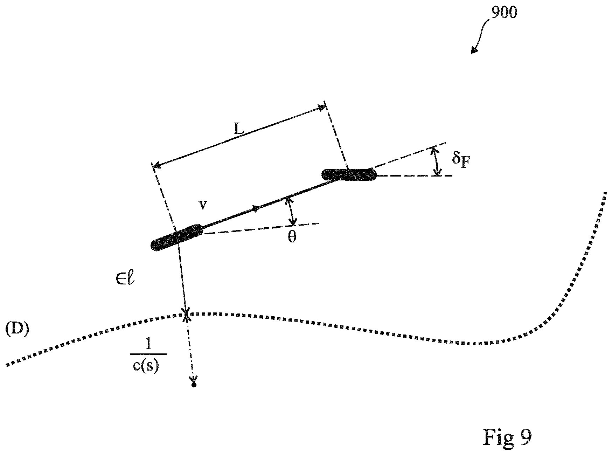

An example of the techniques and systems described herein based on the control of an autonomous vehicle will now be described with reference to Figures 9 to 11.

Figure 9 represents a kinematic robot model 900 according to an example embodiment. In particular, the kinematic robot model 900 corresponds for example to the approximative robotic model 304. The model 900 is based on a four-wheeled mobile robot, with front steering, as represented in Figure 9. The model for example includes, as parameters, the distance between each wheel axis, denoted as the wheel base $L$, and in some cases a maximum range of the turning angle $\delta_F$, and/or a maximum speed $v$ of the robot. The robot is for example controlled to follow a trajectory (D), with $\varepsilon_l$ being a distance of a rear wheel of the robot from this trajectory. A variable $\theta$ in Figure 9 represents the heading of the robot. A variable $1/c(s)$ represents a radius of curvature of the trajectory of the robot at the considered curvilinear abscissa s.

The kinematic model 900 for example returns the following values forming the rate of change vector $\dot{X}_{k,MODEL}$:

$\dot{x}$: the rate of change of the position x of the robot, equal for example to $v\cos(\theta)$;

$\dot{y}$: the rate of change of the position y of the robot, equal for example to $v\sin(\theta)$;

$\dot{v}$: the rate of change of the velocity of the robot, i.e. the acceleration; and

$\dot{\theta}$: the rate of change of the heading of the robot, i.e. the angular speed, equal for example to $v\dfrac{\tan(\delta_F)}{L}$ . L

The correction module 306 is for example configured to estimate corrections $\delta\dot{X}_{k,PRED}$ of these values of the rate of change vector $\dot{X}_{k,MODEL}$.

In this example, the state of the system comprises additional variables that are not returned from the model. These values are the following:

$\dot{\beta}$: the rate of change of the sliding angle $\beta$, the sliding angle $\beta$ being the angle of speed vector with respect to the robot's heading;

$\ddot{\theta}$: angular acceleration;

$\ddot{x}$: the longitudinal acceleration; and

$\ddot{y}$: the lateral acceleration.

In some embodiments, a rear cornering stiffness CR, and/or a front cornering stiffness CF, of the robot can also be taken into account in addition to, or instead of, one or more of the above additional variables. Furthermore, in some embodiments, other input variables, such as a camera input, could be added.

The neural network 308' is for example trained to predict these additional values by adding them to the ground truth vector $y_{k,TRUE}$. As such, the full state vector $X$, and the rate of change vector $\dot{X}$, become:

$$X = \left[ x, y, v, \theta, \beta, \dot{\theta}, \dot{x}, \dot{y} \right]$$

$$\dot{X} = \left[ \dot{x}, \dot{y}, \dot{v}, \dot{\theta}, \dot{\beta}, \ddot{\theta}, \ddot{x}, \ddot{y} \right]$$

However, in the present example, even if the model predicts the values $\dot{x}$, $\dot{y}$ and $\dot{\theta}$, the real world dataset only has the values $x$, $y$ and $\theta$. A solution is to apply a first order derivative using a 7 point stencil to the values that the model predicts. From this, the differences between the real world values and the model values are obtained, which are then used as the target vector value $y_{k,TRUE}$ during training.

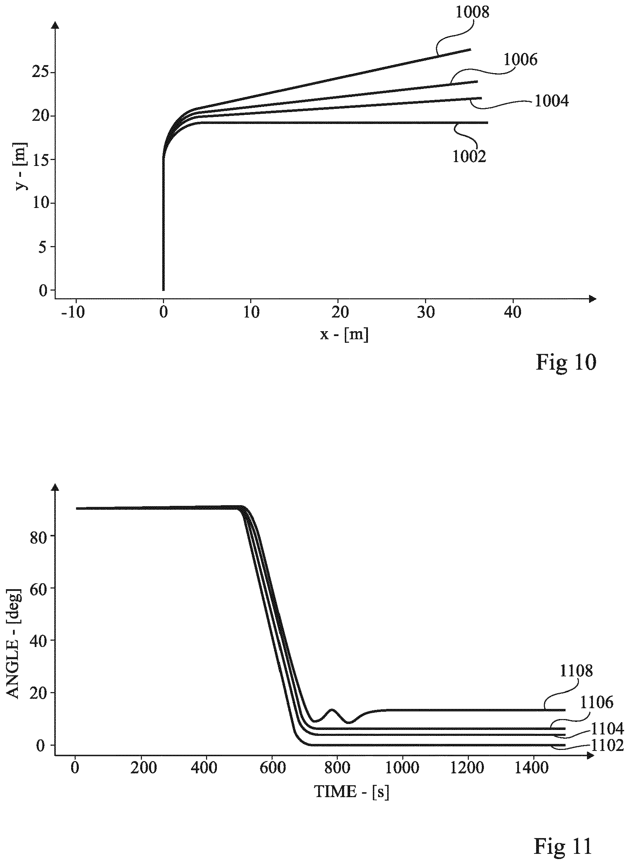

The results that were obtained from the above training are illustrated in Figures 10 and 11.

Figure 10 is a graph representing simulated displacement, in x and y, of a robot vehicle using the robotic system model described herein, wherein the neural network 308 of the correction module 306 was trained to learn the correction based also on the grip conditions defined, for example, by the values CR and CF. In particular, four curves are shown, a curve 1002 based on ideal grip, where it can seen that the robot turns 90 degrees without any sliding, and curves 1004, 1006 and 1008 respectively representing a CR and CF of 30000 $N.rad^{-1}$, 15000 $N.rad^{-1}$ and 7000 $N.rad^{-1}$.

Figure 11 is a graph representing angular heading (ANGLE) of the robot vehicle, and in particular yaw, against time (TIME), using the robotic system model described herein, again based on the varying grip conditions. Four curves are shown, a curve 1102 based on ideal grip, and curves 1004, 1006 and 1008 respectively representing the CR and CF of 30000 $N.rad^{-1}$, 15000 $N.rad^{-1}$ and 7000 $N.rad^{-1}$.

Thus, Figures 10 and 11 illustrate that it is possible, using the combination of the approximative model 304 and correction model 306, to successfully consider variables of the state of the robotic system than are not considered by the approximative model 304. Indeed, CR and CF bring information that is used by the neural network 308, and not by the model 304, in order to predict the desired behavior.

An advantage of the embodiments described herein is that an accurate, stable and reliable model of a robotic system can be provided, allowing simulation of the robotic system. Indeed, by using an approximative model, stability can be assured, while the use of the neural network permits the accuracy to be improved with respect to the approximative model. If, however, a neural network was to be used to as the main part of the model, this would risk stability and reliability issues.

Various embodiments and variants have been described. Those skilled in the art will understand that certain features of these embodiments can be combined and other variants will readily occur to those skilled in the art. For example, while some specific examples of neural networks are described, it will be apparent to those skilled in the art that other types of neural networks could be employed. The inventors have found, however, that particularly good results are obtained using a feed forward fully connection perceptron network. Furthermore, it will be apparent to those skilled in the art that, while software implementations of the neural network and of the approximative model have been described, in alternative embodiments, either or both of these elements could be implemented by dedicated hardware.

**Claims**

1. A method of simulating the behavior of a robotic system (200) using a computing system (400) comprising a processing device (402), the method comprising:

   providing, to an approximative model (304) of the robotic system defined in the computing system, and to a correction module (306) also defined in the computing system, a state vector ($X_k$) indicating a state of the robotic system, and

   a command vector ($U_k$) indicating values of one or more command signals applied to the robotic system, wherein the correction module comprises a trained neural network (308);

   generating, by the processing device using the approximative model, a rate of change vector ($\dot{X}_{MODEL}$) indicating a rate of change over time of the state vector ($X_k$) based on the command vector ($U_k$);

   generating, by the processing device using the trained neural network and based on the state vector and on the command vector, a correction vector ($\delta\dot{X}$) indicating a correction to be applied to the rate of change vector ($\dot{X}_{MODEL}$); and

   estimating, by the processing device, a next state vector ($X_{k+1}$) of the robotic system based on the rate of change vector ($\dot{X}_{MODEL}$) corrected by the correction vector ($\delta\dot{X}$), wherein, in addition to providing the state vector ($X_k$) to the correction module (306), one or more further state values are provided to the correction module (306) and not to the approximative model (304), and wherein the correction vector is generated based on the one or more further state values.

2. The method of claim 1, wherein estimating the next state vector ($X_{k+1}$) of the robotic system comprises correcting the rate of change vector ($\dot{X}_{MODEL}$) by adding to it the correction vector ($\delta\dot{X}$), and multiplying the corrected rate of change vector ($\dot{X}_{PRED}$) by a time step ($dt$).

3. The method of claim 1 or 2, wherein the correction module (306) comprises a normalization module (314) configured to center the state vector ($X_k$) and the command vector ($U_k$) with respect to an activation function of the trained neural network (308).

4. The method of claim 3, wherein the correction module (306) comprises a transformation module (316) configured to apply a principal component analysis transformation to the centered state vector ($X_k$) and the centered command vector ($U_k$).

5. A method of conception, using a computing system (400), of a controller (202) for a robotic system (200), the method comprising simulating the behavior of the robotic system according to the method of any of claims 1 to 4.

6. A method of controlling a robotic system (200), the method comprising:

   generating, by a controller (202) based on at least one signal captured by at least one sensor (206), a current state vector ($X_k$) indicating a current state of the robotic system, and an initial command vector ($U_k$) indicating values of one or more command signals to be applied to the robotic system;
   simulating the behavior of the robot system according to the method of any of claims 1 to 4 to estimate a next state vector ($X_{k+1}$) of the robotic system, wherein the command vector ($U_k$) provided to the correction module (306) is the initial command vector, and the state vector ($U_k$) applied to the correction module is the current state vector ($X_k$);
   generating, by the controller, a corrected command vector ($U_k'$) based on the estimated next state vector ($X_{k+1}$); and
   applying the corrected command vector ($U_k'$) to one or more actuators (208) of the robotic system.

7. A non-transitory storage medium storing computing instructions for executing the method of any of claims 1 to 6 when executed by a processing device.

8. A simulator (102) for simulating the behavior of a robotic system (200), the simulator comprising a computing system (400) including a processing device (402) configured to:

   provide, to an approximative model (304) of the robotic system defined in the computing system, and to a correction module (306) also defined in the computing system, a state vector ($X_k$) indicating a state of the robotic system, and
   a command vector ($U_k$) indicating values of one or more command signals applied to the robotic system, wherein the correction module comprises a trained neural network (308);
   generate, using the approximative model, a rate of change vector ($\dot{X}_{MODEL}$) indicating a rate of change over time of the state vector ($X_k$) based on the command vector ($U_k$);
   generate, using the trained neural network and based on the state vector and on the command vector, a correction vector ($\delta\dot{X}$) indicating a correction to be applied to the rate of change vector ($\dot{X}_{MODEL}$); and
   estimate a next state vector ($X_{k+1}$) of the robotic system based on the rate of change vector ($\dot{X}_{MODEL}$) corrected by the correction vector ($\delta\dot{X}$), wherein, in addition to providing the state vector ($X_k$) to the correction module (306), the processing device (402) is configured to provide to the correction module (306), and not to the approximative model (304), one or more further state values, and wherein the processing device is configured to generate the correction vector further based on the one or more further state values.

9. A controller (202) for a robotic system, the controller comprising the simulator (102) of claim 8, wherein the processing device (402) is further configured to:

   generate, based on at least one signal captured by at least one sensor (206), a current state vector ($X_k$) indicating a current state of the robotic system, and an initial command vector ($U_k$) indicating values of one or more command signals to be applied to the robotic system;
   simulate, using the simulator, the behavior of the robot system to estimate a next state vector ($X_{k+1}$) of the robotic system, wherein the command vector ($U_k$) provided to the correction module (306) is the initial command vector, and

the state vector ($U_k$) applied to the correction module is the current state vector ($X_k$);

generate a corrected command vector ($U_{k\_COR}$) based on the estimated next state vector ($X_{k+1}$); and

apply the corrected command vector ($U_{k\_COR}$) to one or more actuators (208) of the robotic system.

10. The controller (202) of claim 9, wherein estimating the next state vector ($X_{k+1}$) of the robotic system comprises correcting the rate of change vector ($\dot{X}_{MODEL}$) by adding to it the correction vector ($\delta\dot{X}$), and multiplying the corrected rate of change vector ($\dot{X}_{PRED}$) by a time step ($dt$).

11. A robotic system (200) comprising:

the controller (202) of claim 9 or 10;
the at least one sensor (206); and
the one or more actuators (208).

12. The robotic system of claim 11, wherein the robotic system is an autonomous four-wheeled mobile robot, and wherein the one or more further state values indicate a grip condition.

**Patentansprüche**

1. Ein Verfahren zum Simulieren des Verhaltens eines Robotersystems (200) unter Verwendung eines Rechensystems (400), das eine Verarbeitungsvorrichtung (402) aufweist, wobei das Verfahren Folgendes aufweist:

Bereitstellen, an ein approximatives Modell (304) des Robotersystems, das in dem Rechensystem definiert ist, und an ein Korrekturmodul (306), das ebenfalls in dem Rechensystem definiert ist, eines Zustandsvektors ($X_k$), der einen Zustand des Robotersystems anzeigt, und eines Befehlsvektors ($U_k$), der Werte von einem oder mehreren Befehlssignalen anzeigt, die an das Robotersystem angelegt werden, wobei das Korrekturmodul ein trainiertes neuronales Netz (308) aufweist,
Erzeugen, durch die Verarbeitungsvorrichtung unter Verwendung des approximativen Modells, eines Änderungsratenvektors ($\dot{X}_{MODEL}$), der eine Änderungsrate über die Zeit des Zustandsvektors ($X_k$) basierend auf dem Befehlsvektor ($U_k$) anzeigt,
Erzeugen, durch die Verarbeitungsvorrichtung unter Verwendung des trainierten neuronalen Netzes und basierend auf dem Zustandsvektor und auf dem Befehlsvektor, eines Korrekturvektors ($\delta\dot{X}$), der eine Korrektur anzeigt, die auf den Änderungsratenvektor ($\dot{X}_{MODEL}$) anzuwenden ist, und
Schätzen, durch die Verarbeitungsvorrichtung, eines nächsten Zustandsvektors ($X_{k+1}$) des Robotersystems basierend auf dem Änderungsratenvektor ($\dot{X}_{MODEL}$), korrigiert durch den Korrekturvektor ($\delta\dot{X}$), wobei, zusätzlich zum Bereitstellen des Zustandsvektors ($X_k$) an das Korrekturmodul (306), ein oder mehrere weitere Zustandswerte dem Korrekturmodul (306) und nicht dem approximativen Modell (304) bereitgestellt werden, und wobei der Korrekturvektor basierend auf dem einen oder den mehreren weiteren Zustandswerten erzeugt wird.

2. Das Verfahren nach Anspruch 1, wobei das Schätzen des nächsten Zustandsvektors ($X_{k+1}$) des Robotersystems Korrigieren des Änderungsratenvektors ($\dot{X}_{MODEL}$) aufweist, und zwar durch Addieren des Korrekturvektors ($\delta\dot{X}$) zu diesem und Multiplizieren des korrigierten Änderungsratenvektors ($\dot{X}_{PRED}$) mit einem Zeitschritt ($dt$).

3. Das Verfahren nach Anspruch 1 oder 2, wobei das Korrekturmodul (306) ein Normalisierungsmodul (314) aufweist, das eingerichtet ist, um den Zustandsvektor ($X_k$) und den Befehlsvektor ($U_k$) in Bezug auf eine Aktivierungsfunktion des trainierten neuronalen Netzes (308) zu zentrieren.

4. Das Verfahren nach Anspruch 3, wobei das Korrekturmodul (306) ein Transformationsmodul (316) aufweist, das eingerichtet ist, um eine Hauptkomponentenanalyse-Transformation auf den zentrierten Zustandsvektor ($X_k$) und den zentrierten Befehlsvektor ($U_k$) anzuwenden.

5. Ein Verfahren zur Konzeption, unter Verwendung eines Rechensystems (400), einer Steuerung (202) für ein Robotersystem (200), wobei das Verfahren die Simulation des Verhaltens des Robotersystems gemäß dem Verfahren nach einem der Ansprüche 1 bis 4 aufweist.

6. Ein Verfahren zur Steuerung eines Robotersystems (200), wobei das Verfahren Folgendes aufweist:

Erzeugen, durch eine Steuerung (202), basierend auf wenigstens einem von wenigstens einem Sensor (206) erfassten Signal, eines aktuellen Zustandsvektors ($X_k$), der einen aktuellen Zustand des Robotersystems anzeigt, und eines anfänglichen Befehlsvektors ($U_k$), der Werte von einem oder mehreren Befehlssignalen anzeigt, die auf das Robotersystem anzuwenden sind;

Simulieren des Verhaltens des Robotersystems gemäß dem Verfahren nach einem der Ansprüche 1 bis 4, um einen nächsten Zustandsvektor ($X_{k+1}$) des Robotersystems abzuschätzen, wobei der Befehlsvektor ($U_k$), der dem Korrekturmodul (306) bereitgestellt wird, der anfängliche Befehlsvektor ist, und der Zustandsvektor ($U_k$), der auf das Korrekturmodul angewendet wird, der aktuelle Zustandsvektor ($X_k$) ist,

Erzeugen, durch die Steuerung, eines korrigierten Befehlsvektors ($U_k'$) basierend auf dem geschätzten nächsten Zustandsvektor ($X_{k+1}$); und

Anwenden des korrigierten Befehlsvektors ($U_k'$) auf einen oder mehrere Aktuatoren (208) des Robotersystems.

7. Ein nicht-flüchtiges Speichermedium, das Computerbefehle speichert, zum Ausführen des Verfahrens nach einem der Ansprüche 1 bis 6, wenn es durch eine Verarbeitungsvorrichtung ausgeführt wird.

8. Ein Simulator (102) zum Simulieren des Verhaltens eines Robotersystems (200), wobei der Simulator ein Rechensystem (400) aufweist, das eine Verarbeitungsvorrichtung (402) enthält, die eingerichtet ist, zum:

Bereitstellen, an ein approximatives Modell (304) des Robotersystems, das in dem Rechensystem definiert ist, und an ein Korrekturmodul (306), das ebenfalls in dem Rechensystem definiert ist, eines Zustandsvektors ($X_k$), der einen Zustand des Robotersystems anzeigt, und eines Befehlsvektors ($U_k$), der Werte von einem oder mehreren Befehlssignalen anzeigt, die an das Robotersystem angelegt werden, wobei das Korrekturmodul ein trainiertes neuronales Netz (308) aufweist,

Erzeugen, unter Verwendung des approximativen Modells, eines Änderungsratenvektors ($\dot{X}_{MODEL}$), der eine Änderungsrate über die Zeit des Zustandsvektors ($X_k$) basierend auf dem Befehlsvektor ($U_k$) anzeigt,

Erzeugen, unter Verwendung des trainierten neuronalen Netzes und basierend auf dem Zustandsvektor und dem Befehlsvektor, eines Korrekturvektors ($\dot{\delta X}$), der eine Korrektur anzeigt, die auf den Änderungsratenvektor ($\dot{X}_{MODEL}$) anzuwenden ist, und Schätzen eines nächsten Zustandsvektors ($X_{k+1}$) des Robotersystems basierend auf dem Änderungsratenvektor ($\dot{X}_{MODEL}$), korrigiert durch den Korrekturvektor ($\dot{\delta X}$), wobei, zusätzlich zum Bereitstellen des Zustandsvektors ($X_k$) an das Korrekturmodul (306), die Verarbeitungsvorrichtung (402) eingerichtet ist zum Bereitstellen an das Korrekturmodul (306), und nicht an das approximative Modell (304), eines oder mehrerer weiterer Zustandswerte, und wobei die Verarbeitungsvorrichtung eingerichtet ist zum Erzeugen des Korrekturvektors weiter basierend auf dem einen oder den mehreren weiteren Zustandswerten.

9. Eine Steuerung (202) für ein Robotersystem, wobei die Steuerung den Simulator (102) von Anspruch 8 aufweist, wobei die Verarbeitungsvorrichtung (402) ferner eingerichtet ist, zum:

Erzeugen basierend auf wenigstens einem von wenigstens einem Sensor (206) erfassten Signal, eines aktuellen Zustandsvektors ($X_k$), der einen aktuellen Zustand des Robotersystems anzeigt, und eines anfänglichen Befehlsvektors ($U_k$),

der Werte von einem oder mehreren Befehlssignalen anzeigt, die auf das Robotersystem anzuwenden sind;

Simulieren, unter Verwendung des Simulators, des Verhaltens des Robotersystems, um einen nächsten Zustandsvektor ($X_{k+1}$) des Robotersystems abzuschätzen, wobei der Befehlsvektor ($U_k$), der dem Korrekturmodul (306) bereitgestellt wird, der anfängliche Befehlsvektor ist, und der Zustandsvektor ($U_k$), der auf das Korrekturmodul angewendet wird, der aktuelle Zustandsvektor ($X_k$) ist; Erzeugen eines korrigierten Befehlsvektors ($U_k$) basierend auf dem geschätzten nächsten Zustandsvektor ($X_{k+1}$); und

Anwenden des korrigierten Befehlsvektors ($U_k'$) auf einen oder mehrere Aktuatoren (208) des Robotersystems.

10. Die Steuerung (202) nach Anspruch 9, wobei das Schätzen des nächsten Zustandsvektors ($X_{k+1}$) des Robotersystems das Korrigieren des Änderungsratenvektors ($\dot{X}_{MODEL}$) aufweist, und zwar durch Addieren des Korrekturvektors ($\dot{\delta X}$) zu diesem und Multiplizieren des korrigierten Änderungsratenvektors ($\dot{X}_{PRED}$) mit einem Zeitschritt (dt).

11. Ein Robotersystem (200), das Folgendes aufweist:

die Steuerung (202) nach Anspruch 9 oder 10;
den mindestens einen Sensor (206), und
den einen oder die mehreren Aktuatoren (208).

**12.** Das Robotersystem nach Anspruch 11, wobei das Robotersystem ein autonomer vierrädriger mobiler Roboter ist und wobei der eine oder die mehreren weiteren Zustandswerte einen Griffzustand anzeigen.

**Revendications**

**1.** Procédé de simulation du comportement d'un système robotique (200) à l'aide d'un système informatique (400) comprenant un dispositif de traitement (402), le procédé comprenant :

la fourniture, à un modèle approximatif (304) du système robotique défini dans le système informatique et à un module de correction (306) également défini dans le système informatique, d'un vecteur d'état ($X_k$) indiquant un état du système robotique, et d'un vecteur de commande ($U_k$) indiquant des valeurs d'un ou de plusieurs signaux de commande appliqués au système robotique, dans lequel le module de correction comprend un réseau neuronal entraîné (308) ;

la génération, par le dispositif de traitement à l'aide du modèle approximatif, d'un vecteur de taux de changement ($\dot{X}_{MODEL}$) indiquant un taux de changement dans le temps du vecteur d'état ($X_k$) sur la base du vecteur de commande ($U_k$) ;

la génération, par le dispositif de traitement à l'aide du réseau neuronal entraîné et sur la base du vecteur d'état et du vecteur de commande, d'un vecteur de correction ($\delta\dot{X}$) indiquant une correction à appliquer au vecteur de taux de changement ($\dot{X}_{MODEL}$) ; et

l'estimation, par le dispositif de traitement, d'un vecteur d'état suivant ($X_{k+1}$) du système robotique sur la base du vecteur de taux de changement ($\dot{X}_{MODEL}$) corrigé par le vecteur de correction ($\delta\dot{X}$), dans lequel, en plus de fournir le vecteur d'état ($X_k$) au module de correction (306), une ou plusieurs valeurs d'état supplémentaires sont fournies au module de correction (306) et non au modèle approximatif (304), et dans lequel le vecteur de correction est généré sur la base des une ou plusieurs valeurs d'état supplémentaires.

**2.** Procédé selon la revendication 1, dans lequel l'estimation du vecteur d'état suivant ($X_{k+1}$) du système robotique comprend la correction du vecteur de taux de changement ($\dot{X}_{MODEL}$) en lui ajoutant le vecteur de correction ($\delta\dot{X}$), et la multiplication du vecteur de taux de changement corrigé ($\dot{X}_{PRED}$) par un pas de temps (dt) .

**3.** Procédé selon la revendication 1 ou 2, dans lequel le module de correction (306) comprend un module de normalisation (314) configuré pour centrer le vecteur d'état ($X_k$) et le vecteur de commande ($U_k$) par rapport à une fonction d'activation du réseau neuronal entraîné (308).

**4.** Procédé selon la revendication 3, dans lequel le module de correction (306) comprend un module de transformation (316) configuré pour appliquer une transformation d'analyse de composantes principales au vecteur d'état centré ($X_k$) et au vecteur de commande centré ($U_k$).

**5.** Procédé de conception, à l'aide d'un système informatique (400), d'un contrôleur (202) pour un système robotique (200), le procédé comprenant la simulation du comportement du système robotique selon le procédé de l'une quelconque des revendications 1 à 4.

**6.** Procédé de commande d'un système robotique (200), le procédé comprenant :

la génération, par un contrôleur (202) sur la base d'au moins un signal capturé par au moins un capteur (206), d'un vecteur d'état courant ($X_k$) indiquant un état courant du système robotique, et d'un vecteur de commande initial ($U_k$) indiquant des valeurs d'un ou de plusieurs signaux de commande à appliquer au système robotique ;

la simulation du comportement du système robotique selon le procédé selon l'une quelconque des revendications 1 à 4 pour estimer un vecteur d'état suivant ($X_{k+1}$) du système robotique, dans lequel le vecteur de commande ($U_k$) fourni au module de correction (306) est le vecteur initial de commande, et le vecteur d'état ($U_k$) appliqué au module de correction est le vecteur d'état courant ($X_k$);

la génération, par le contrôleur, d'un vecteur de commande corrigé ($U_k'$) sur la base du vecteur d'état suivant estimé ($X_{k+1}$) ; et

l'application du vecteur de commande corrigé ($U_k'$) à un ou plusieurs actionneurs (208) du système robotique.

**7.** Support de stockage non transitoire stockant des instructions informatiques pour exécuter le procédé selon l'une quelconque des revendications 1 à 6 lorsqu'il est exécuté par un dispositif de traitement.

8. Simulateur (102) pour simuler le comportement d'un système robotique (200), le simulateur comprenant un système informatique (400) comportant un dispositif de traitement (402) configuré pour :

fournir, à un modèle approximatif (304) du système robotique défini dans le système informatique, et à un module de correction (306) également défini dans le système informatique, un vecteur d'état ($X_k$) indiquant un état du système robotique, et un vecteur de commande ($U_k$) indiquant des valeurs d'un ou de plusieurs signaux de commande appliqués au système robotique, dans lequel le module de correction comprend un réseau neuronal entraîné (308) ;

générer, à l'aide du modèle approximatif, un vecteur de taux de changement ($\dot{X}_{MODEL}$) indiquant un taux de changement dans le temps du vecteur d'état ($X_k$) sur la base du vecteur de commande ($U_k$) ;

générer, à l'aide du réseau neuronal entraîné et sur la base du vecteur d'état et du vecteur de commande, un vecteur de correction ($\delta\dot{X}$) indiquant une correction à appliquer au vecteur de taux de changement ($\dot{X}_{MODEL}$) ; et

estimer un vecteur d'état suivant ($X_{k+1}$) du système robotique sur la base du vecteur de taux de changement ($\dot{X}_{MODEL}$) corrigé par le vecteur de correction ($\delta\dot{X}$), dans lequel, en plus de fournir le vecteur d'état ($X_k$) au module de correction (306), le dispositif de traitement (402) est configuré pour fournir au module de correction (306) et non au modèle approximatif (304), une ou plusieurs valeurs d'état supplémentaires et dans lequel le dispositif de traitement est configuré pour générer le vecteur de correction également sur la base des une ou plusieurs valeurs d'état supplémentaires.

9. Contrôleur (202) pour un système robotique, le contrôleur comprenant le simulateur (102) selon la revendication 8, dans lequel le dispositif de traitement (402) est en outre configuré pour :

générer, sur la base d'au moins un signal capturé par au moins un capteur (206), un vecteur d'état courant ($X_k$) indiquant un état courant du système robotique, et un vecteur de commande initial ($U_k$) indiquant des valeurs d'un ou de plusieurs signaux de commande à appliquer au système robotique ;

simuler, à l'aide du simulateur, le comportement du système robotique pour estimer un vecteur d'état suivant ($X_{k+1}$) du système robotique, dans lequel le vecteur de commande ($U_k$) fourni au module de correction (306) est le vecteur de commande initial, et le vecteur d'état ($U_k$) appliqué au module de correction est le vecteur d'état courant ($X_k$) ;

générer un vecteur de commande corrigé ($U_{k\_COR}$) sur la base du vecteur d'état suivant estimé ($X_{k+1}$) ; et

appliquer le vecteur de commande corrigé ($U_{k\_COR}$) à un ou plusieurs actionneurs (208) du système robotique.

10. Contrôleur (202) selon la revendication 9, dans lequel l'estimation du vecteur d'état suivant ($X_{k+1}$) du système robotique comprend la correction du vecteur de taux de changement ($\dot{X}_{MODEL}$) en lui ajoutant le vecteur de correction ($\delta\dot{X}$), et la multiplication du vecteur de taux de changement corrigé. ($\dot{X}_{PRED}$) par un pas de temps (dt).

11. Système robotique (200) comprenant :

le contrôleur (202) selon la revendication 9 ou 10 ;
l'au moins un capteur (206) ; et
les un ou plusieurs actionneurs (208).

12. Système robotique selon la revendication 11, dans lequel le système robotique est un robot mobile autonome à quatre roues, et dans lequel les une ou plusieurs valeurs d'état supplémentaires indiquent une condition de préhension.

Fig 1

Fig 2

Fig 3

Fig 4

Fig 5

Fig 6

Fig 7

Fig 8

Fig 9

Fig 10

Fig 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20200156241 A

### Non-patent literature cited in the description

- **ERDOGMUS DENIZ et al.** A Neural Network Perspective to Extended Luenberger Observers. *MEASUREMENT AND CONTROL,* 01 February 2002, vol. 35 (1), 10-16
- On approximate NN realization of an unknown dynamic system from its input-output history. **HOVAKIMYAN N et al.** AMERICAN CONTROL CONFERENCE, 2000, PROCEEDINGS OF THE 2000 JUNE 28-30, 2000. IEEE, 28 June 2000, vol. 2, 919-923
- **K. PEARSON.** Liii. on lines and planes of closest fit to systems of points in space. *The London, Edinburgh and Dublin Philosophical Magazine and Journal of Science,* 1901, vol. 2 (11), 559-572
- **L. BOTTOU ; F. E. CURTIS ; J. NOCEDAL.** Optimization methods for large-scale machine learning. *Siam Review,* 2018, vol. 60 (2), 223-311
- **K. HE ; X.ZHANG ; S. REN ; J. SUN.** Deep residual learning for image recognition. *Proceedings of the IEEE conference on computer vision and pattern recognition,* 2016, 770-778
- **X. GLOROT ; A. BORDES ; Y. BENGIO.** Deep sparse rectifier neural networks. *Proceedings of the fourteenth international conference on artificial intelligence and statistics,* 2011, 315-323
- **S. IOFFE ; C. SZEGEDY.** *Batch normalization: Accelerating deep network training by reducing internal covariate shift,* 2015